# EUROPEAN PATENT APPLICATION

(11) **EP 4 730 386 A1**
(43) Date of publication of application: **22.04.2026**
(21) Application number: 25205633.8
(22) Date of filing: 30.09.2025
(51) Int. Cl.: H01J 37/145

(54) **ELECTRON BEAM INSPECTION DEVICE**

(30) Priority: 18.10.2024 JP 2024184110
(71) Applicant: EBARA CORPORATION, Ota-ku, Tokyo 144-8510 (JP)
(72) Inventor: MURAKAMI, Takeshi, Tokyo, 144-8510 (JP)
(74) Representative: Pritzlaff, Stefanie Lydia

(57) **Abstract**

An electron beam inspection device includes an objective lens that forms an image of a primary electron beam on a negatively biased sample. The lens comprises an electromagnetic lens with a Wehnelt electrode facing the sample, to which a negative potential is applied, and a yoke disposed opposite the sample, magnetically connected to the Wehnelt electrode but electrically insulated. A magnetic field is generated in the gap between their inner-diameter ends. A positive potential electrode is placed opposite the sample, and a ground electrode is positioned between the Wehnelt and positive electrodes to prevent backscattered electrons from colliding with the positive electrode.

## Description

### CROSS-REFERENCE TO RELATED APPLICATIONS

This application claims the benefit of Japanese Priority Patent Application JP 2024-184110 filed on October 18, 2024, the entire contents of which are incorporated herein by reference.

### FIELD

The present technology relates to an electron beam inspection device.

### BACKGROUND AND SUMMARY

Electron beam inspection devices that irradiate a sample with an electron beam and observe an electron beam emitted from the sample are known (for example, Japanese Patent No. 5886663). The electron beam inspection devices include a primary optical system that irradiates a sample with a primary electron beam and a secondary optical system that detects a secondary electron beam generated from the sample as an image.

By constituting the primary electron beam in the primary optical system with a plurality of electron beams, a high throughput can be achieved. In such electron beam inspection devices, an electron beam emitted from an electron source passes through a multi-beam generation mechanism provided with a plurality of openings, so that a primary electron beam including a plurality of primary electrons is generated. The generated primary electron beams are individually converged by a transfer lens and an objective lens, and radiated on a plurality of sites on the sample at equal intervals. In addition, the primary electron beams are deflected to scan the sample two-dimensionally by a scan deflector disposed between the transfer lens and the objective lens. Therefore, the primary electron beams emitted discretely are uniformly radiated on the sample.

As a means for switching between a state in which a plurality of electron beams are radiated on a sample and a state in which a plurality of electron beams are not radiated on the sample, a means called blanking is known in which a predetermined voltage or current is applied to a deflector element disposed on the upstream side of an objective lens to deflect the plurality of electron beams, and a Faraday cup disposed between the deflector and the objective lens is irradiated with the entire amount of the plurality of electron beams so that the sample is not irradiated with the plurality of electron beams. As the deflector used here, a deflector dedicated to blanking may be disposed, or a deflector that also serves as a deflector for axis adjustment or scanning may be used.

Blanking release means that a predetermined voltage or current for blanking applied to the deflector is set to zero, and the plurality of electron beams radiated on the Faraday cup are radiated on the sample.

In a case where a plurality of electron beams are radiated on the sample, electrons having a wide range of energy from energy close to zero to irradiation energy are emitted from the sample. In general, among the electrons emitted from the sample, electrons having energy of 50 eV to the irradiation energy are referred to as backscattered electrons, and electrons having energy of the energy close to zero to 50 eV are referred to as secondary electrons.

Japanese Patent No. 5886663 discloses that a ground electrode is disposed on the upstream side of a surface electric field control electrode so that an electric field including a negative potential applied to the surface electric field control electrode and the sample does not leak to the upstream side.

Meanwhile, as an objective lens, an electromagnetic field superposition type objective lens using a positive potential electrode is known together with a magnetic field lens. The positive potential electrode increases electron energy by positively increasing the potential in the vicinity of a position where a plurality of electron beams converge, thereby reducing the residence time of the electrons. This reduces the space charge effect, and particularly, suppresses an increase in beam spot size when the beam current is large. The relative permeability of the material of the positive potential electrode is about the same as that of a vacuum, and no magnetic lens action is exerted on the electron beams passing through an inner diameter part. Meanwhile, the presence of the positive potential electrode creates some electrostatic lens action on the electron beams passing through the inner diameter part.

In the configuration of an objective lens according to the related art, the secondary electrons emitted from a sample are converged by a magnetic field of the objective lens, and thus do not collide with the positive potential electrode. On the other hand, since the backscattered electrons have high energy, they are not sufficiently converged by the magnetic field of the objective lens, and many of them collide with the positive potential electrode.

Therefore, immediately after the blanking is released, the radiation of backscattered electrons on the positive potential electrode instantaneously transits from a zero state to a state in which a certain number of backscattered electrons are radiated. Since the positive potential of the positive potential electrode is due to the accumulation of positive charges in the electrode, an instantaneous change in the inflow electrons causes an instantaneous potential change of the positive potential electrode.

Due to the potential change of the positive potential electrode, the objective lens is caused to shift from its focus by a change in the electrostatic lens action, leading to an increase in beam spot size and a decrease in secondary electron detection efficiency. In addition, since the inspection data cannot be used until the potential returns to its original value, the throughput of the inspection decreases.

It is desirable to provide an electron beam inspection device capable of reducing a potential change of a positive potential electrode immediately after blanking is released.

An electron beam inspection device according to one aspect of the present technology includes:
a primary optical system that irradiates a sample on a stage with a primary electron beam including a plurality of primary electrons; and a secondary optical system that detects, with a detector, a secondary electron beam including a plurality of secondary electrons emitted from the sample irradiated with the primary electron beam,
in which an objective lens that forms an image of the primary electron beam on the sample is provided,
a negative potential is applied to the sample, and the objective lens has
an electromagnetic lens that has a Wehnelt electrode that is disposed to face the sample and to which a negative potential is applied, and a yoke that is disposed on a side opposite to the sample as viewed from the Wehnelt electrode, is magnetically connected to the Wehnelt electrode, and is electrically insulated, and forms a magnetic field in a gap between an inner-diameter-side end part of the Wehnelt electrode and an inner-diameter-side end part of the yoke,
a positive potential electrode that is disposed on a side opposite to the sample as viewed from the Wehnelt electrode and to which a positive potential is applied, and
a ground electrode that is disposed between the Wehnelt electrode and the positive potential electrode to inhibit collision of backscattered electrons emitted from the sample with the positive potential electrode, and is electrically grounded.

### BRIEF DESCRIPTION OF DRAWINGS

FIG. 1 is a diagram showing a schematic configuration of an electron beam inspection device according to one embodiment;
FIG. 2 is an enlarged view showing a configuration of an objective lens according to one embodiment;
FIG. 3 is an enlarged view showing a configuration of an objective lens according to the related art; and
FIG. 4 is a graph showing an example of frequency distributions of electron collision positions.

### DETAILED DESCRIPTION OF NON-LIMITING EXAMPLE EMBODIMENTS

An electron beam inspection device according to a first aspect of an embodiment includes:
a primary optical system that irradiates a sample on a stage with a primary electron beam including a plurality of primary electrons; and a secondary optical system that detects, with a detector, a secondary electron beam including a plurality of secondary electrons emitted from the sample irradiated with the primary electron beam,
in which an objective lens that forms an image of the primary electron beam on the sample is provided,
a negative potential is applied to the sample, and the objective lens has
an electromagnetic lens that has a Wehnelt electrode that is disposed to face the sample and to which a negative potential is applied, and a yoke that is disposed on a side opposite to the sample as viewed from the Wehnelt electrode, is magnetically connected to the Wehnelt electrode, and is electrically insulated, and forms a magnetic field in a gap between an inner-diameter-side end part of the Wehnelt electrode and an inner-diameter-side end part of the yoke,
a positive potential electrode that is disposed on a side opposite to the sample as viewed from the Wehnelt electrode and to which a positive potential is applied, and
a ground electrode that is disposed between the Wehnelt electrode and the positive potential electrode to inhibit collision of backscattered electrons emitted from the sample with the positive potential electrode, and is electrically grounded.

According to such an aspect, since the ground electrode is disposed between the Wehnelt electrode and the positive potential electrode, a large number of backscattered electrons are radiated on the ground electrode, and the radiation of backscattered electrons on the positive potential electrode can be reduced. Therefore, it is possible to reduce a potential change of the positive potential electrode immediately after blanking release, and it is possible to reduce an increase in beam spot size and a decrease in secondary electron detection efficiency due to the potential change of the positive potential electrode.

An electron beam inspection device according to a second aspect of the embodiment is the electron beam inspection device according to the first aspect,
in which an inner diameter of the ground electrode is smaller than an inner diameter of the positive potential electrode.

An electron beam inspection device according to a third aspect of the embodiment is the electron beam inspection device according to the second aspect,
in which in a case where the inner diameter of the positive potential electrode is 1, the inner diameter of the ground electrode is 0.7 or less.

An electron beam inspection device according to a fourth aspect of the embodiment is the electron beam inspection device according to the second or third aspect,
in which in a case where the inner diameter of the positive potential electrode is 1, the inner diameter of the ground electrode is 0.2 or more.

Hereinafter, specific examples of embodiments will be described in detail with reference to the accompanying drawings. In the following description and the drawings used in the following description, the same reference numerals are used for parts that can be configured identically, and duplicated description is omitted.

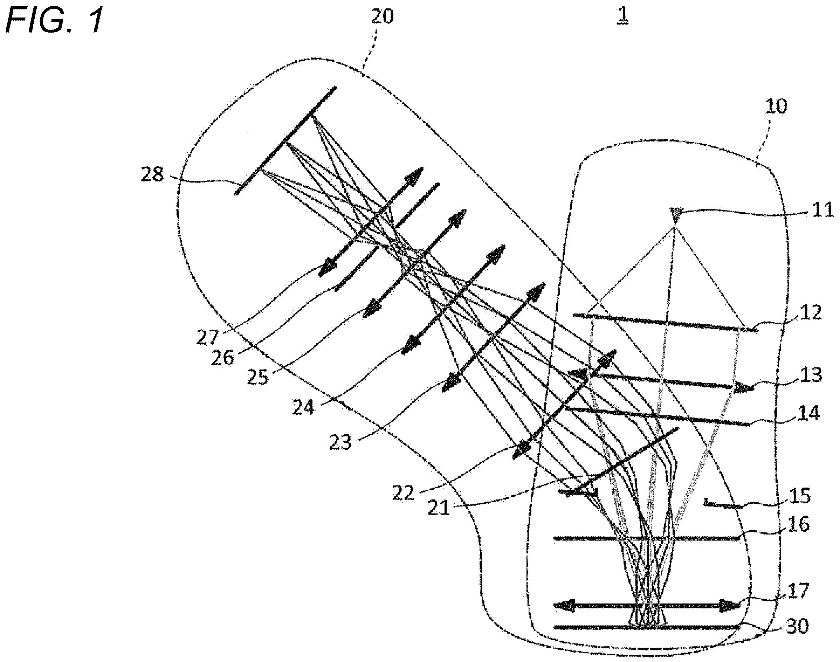

FIG. 1 is a diagram showing a schematic configuration of an electron beam inspection device 1 according to one embodiment. A sample 30 to be inspected by the electron beam inspection device 1 may be, for example, a silicon wafer, a glass mask, a semiconductor substrate, a semiconductor pattern substrate, a substrate having a metal film, or the like.

As shown in FIG. 1, the electron beam inspection device 1 has a primary optical system 10 (also referred to as an irradiation system or a multi-beam optical system) that irradiates a sample 30 on a stage (not shown) with an electron beam, and a secondary optical system 20 (also referred to as an imaging system or a projection optical system) that forms an enlarged image of signal electrons (secondary electrons, reflected electrons, or the like) from the sample on a detector 28.

Among these, the primary optical system 10 converges and emits a primary electron beam including a plurality of primary electrons to a plurality of sites on the sample 30, and has an electron source 11, a multi-beam generation mechanism 12, a transfer lens 13, a deflector 14, a Faraday cup 15, a beam separator 16, and an objective lens 17.

The electron source 11 is provided at one end of a column (vacuum tube) (not shown), and emits an electron beam into the column. As the electron source 11, for example, a photoelectron source having a laser light source and a photoelectric surface as described in JP 2012-253007 A can be used. The photoelectric surface structure used for the photoelectron source can realize high efficiency. The electron source 11 is not limited to the photoelectron source as long as it can emit an electron beam, and for example, an electron gun such as LaB₆ can also be used.

The electron beam emitted from the electron source 11 is appropriately accelerated by an accelerator (not shown) and expanded by a lens (not shown), and is incident on the multi-beam generation mechanism 12.

The multi-beam generation mechanism 12 has a plurality of openings through which multiple beams pass. The electron beam from the electron source 11 passes through the plurality of openings formed in the multi-beam generation mechanism 12, and thus a primary electron beam including a plurality of primary electrons is generated. The generated primary electron beams are individually converged by the transfer lens 13 and the objective lens 17, and radiated on a plurality of sites on the sample 30 placed on a stage (not shown) at equal intervals.

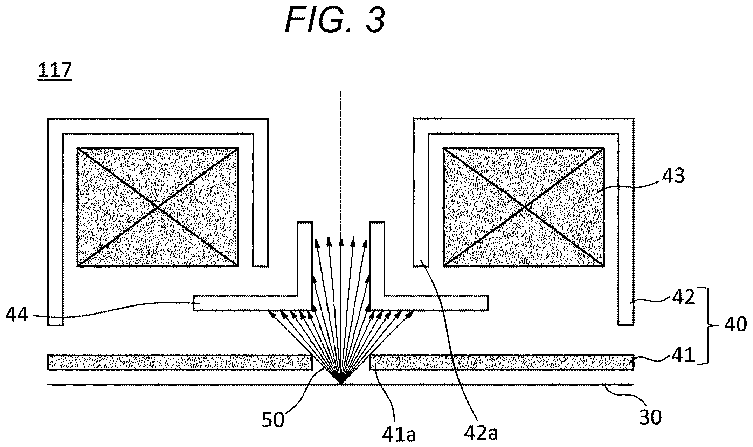

In the example shown in FIG. 1, a primary electron beam including a plurality of primary electrons is generated using the multi-beam generation mechanism 12 having the plurality of openings. However, the configuration for generating a primary electron beam is not limited to the configuration using the multi-beam generation mechanism 12 having the plurality of openings. For example, a plurality of electron sources may be provided instead of the electron source 11 and the multi-beam generation mechanism 12, and a primary electron beam including a plurality of primary electrons may be generated by each of the electron sources emitting electron beams. As the multi-beam generation mechanism 12, as well as a mechanism having a plurality of openings, a field emitter array (for example, see FIG. 10 of JP 2005-213567 A) and a multi-lens barrel (for example, see FIGS. 3, 8, and 9 of JP 2005-197121 A) in which a plurality of single primary electron beam lens barrels are bundled have been known, but the multi-beam generation mechanism 12 is not limited thereto.

Although three primary electron beams are schematically shown in FIG. 1, the number of primary electron beams is not particularly limited. The number of primary electron beams ranges from several to 1,000 or more, for example.

The deflector 14 is disposed between the transfer lens 13 and the objective lens 17, and deflects a traveling direction of the primary electron beam in an XY direction. Therefore, the primary electron beams emitted discretely scan the sample 30 uniformly in two dimensions.

The Faraday cup 15 is disposed between the deflector 14 and the objective lens 17. By applying a predetermined voltage or current to the deflector 14 disposed on the upstream side of the objective lens 17 to deflect a plurality of electron beams, and irradiating the Faraday cup 15 with the entire amount of the plurality of electron beams, a state in which the plurality of electron beams are not radiated on the sample 30 can be obtained (blanking). In addition, by setting the predetermined voltage or current for blanking applied to the deflector 14 to zero, it is possible to create a state in which the plurality of electron beams radiated on the Faraday cup 15 are radiated on the sample 30 (blanking release). In FIG. 1, the deflector 14 has both of two functions: a scanning function; and a blanking function. However, a deflector dedicated to blanking and its release may be disposed separately from the deflector 14.

The secondary optical system 20 detects a secondary electron beam including a plurality of secondary electrons emitted from the sample 30 irradiated with the primary electron beam by the detector 28, and has the objective lens 17, the beam separator 16, a beam bender 21, a first relay lens 22, a second relay lens 23, a dispersion corrector 24, a field lens 25, an aperture diaphragm 26, a projection lens 27, and the detector 28. The objective lens 17 and the beam separator 16 are shared with the primary optical system 10.

The secondary electron beam from the sample 30 is converged by the objective lens 17. The secondary electron beam is bent in a direction different from that of the primary optical system 10 by the beam separator 16 forming a superimposed field between an electric field and a magnetic field, and then further bent by the beam bender 21.

The first relay lens 22 and the second relay lens 23 are adjusted so that the secondary electron beam forms an image with a certain size at a certain position in the vicinity of a lens main surface of the field lens 25 regardless of the potential of the sample 30. By providing the first relay lens 22 and the second relay lens 23, it is possible to handle a wide range of sample potentials.
The secondary electron beam that has passed through the beam separator 16 and the beam bender 21 is dispersed due to its wide range of energy. A dispersion corrector 24 may be disposed between the beam bender 21 and the field lens 25 to correct the dispersion.

The field lens 25 generates an electric field or a magnetic field to adjust the trajectory of the secondary electron beam so that the plurality of secondary electrons constituting the secondary electron beam are closest to each other at the optical axis center in the vicinity of the position of the aperture diaphragm 26. In other words, the aperture diaphragm 26 is disposed at a position where the plurality of secondary electrons are closest to each other at the optical axis center.

The aperture diaphragm 26 has an opening part, and only the secondary electron beam that has passed through the opening part reaches the projection lens 27. Therefore, the opening angle of the secondary electron beam is specified.

The projection lens 27 forms, on the detector 28, an image of the secondary electron beam that has passed through the opening part of the aperture diaphragm 26. The detector 28 has a plurality of detectors corresponding to a plurality of secondary electron beams. It includes, for example, a scintillator and a plurality of photodetectors corresponding to a plurality of secondary electron beams disposed behind the scintillator. By determining the grayscale of pixel according to the current value of each of the plurality of detectors, a plurality of images can be acquired at the same time, and a surface of the sample can be inspected using the plurality of images.

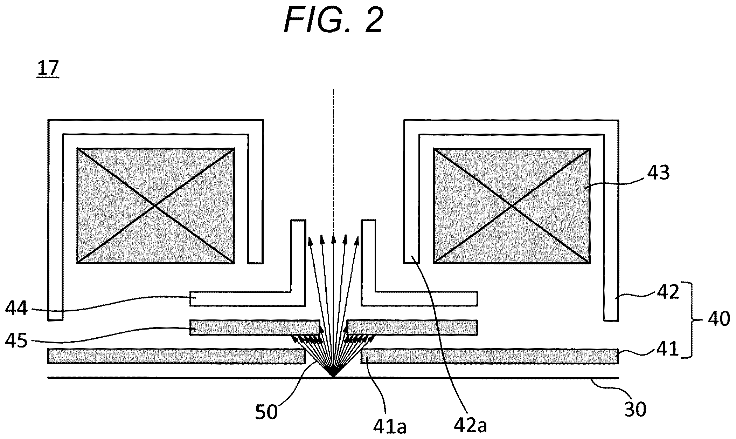

FIG. 2 is an enlarged view showing a configuration of the objective lens 17 according to one embodiment. As shown in FIG. 2, the objective lens 17 according to the present embodiment is an electromagnetic field superposition type objective lens, and has an electromagnetic lens 40 and a positive potential electrode 44.

Among these, the electromagnetic lens 40 has a Wehnelt electrode 41 that is disposed to face the sample 30, has an annular shape, and is made of a high-permeability material, and a yoke 42 that is disposed on a side opposite to the sample 30 as viewed from the Wehnelt electrode 41 (that is, disposed so that the Wehnelt electrode 41 is sandwiched between the sample 30 and the yoke 42), is magnetically connected to the Wehnelt electrode 41, and is electrically insulated from the Wehnelt electrode 41. A negative potential is applied to the sample 30, and the same potential as that of the sample 30 or a potential having a difference of several kV from the potential applied to the sample 30 (both of the potentials are negative) is applied to the Wehnelt electrode 41. The yoke 42 is electrically grounded.

A coil 43 is disposed inside the yoke 42. The coil 43 is wound circumferentially around an optical axis. In a case where a current is applied to the coil 43 to generate a magnetic field, a magnetic flux is generated so as to connect from the yoke 42 to the Wehnelt electrode 41, and a magnetic field (lens magnetic field) is formed in a gap between an inner-diameter-side end part 41a of the Wehnelt electrode 41 and an inner-diameter-side end part 42a of the yoke 42.

The positive potential electrode 44 has a cylindrical or annular shape, and is disposed on the inner diameter side of the yoke 42. The positive potential electrode 44 is formed of a nonmagnetic metal (for example, copper). The positive potential electrode 44 increases electron energy by positively increasing the space potential in the vicinity of a position where a plurality of electron beams converge, thereby reducing the residence time of the electrons. This reduces the space charge effect, and particularly, suppresses an increase in beam spot size when the beam current is large.

As shown in FIG. 2, the objective lens 17 according to the present embodiment further includes a ground electrode 45. The ground electrode 45 has an annular shape and is electrically grounded. The ground electrode 45 is disposed between the Wehnelt electrode 41 and the positive potential electrode 44 to inhibit collision of backscattered electrons 50 emitted from the sample 30 with the positive potential electrode 44. The ground electrode 45 is formed of a nonmagnetic metal (for example, copper).

The ground electrode 45 is disposed along an equipotential line (plane) of a ground potential of a space potential formed between the positive potential electrode 44 to which a positive potential is applied and the Wehnelt electrode 41 to which a negative potential is applied.

As described above, in the configuration of an objective lens 117 (see FIG. 3) according to the related art in which the ground electrode 45 is not provided, the secondary electrons emitted from the sample 30 are converged by a magnetic field of the objective lens 117, and thus do not collide with the positive potential electrode 44. On the other hand, since backscattered electrons 50 have high energy, they are not sufficiently converged by the magnetic field of the objective lens 117, and many of them collide with the positive potential electrode 44.

Therefore, immediately after the blanking is released, the radiation of the backscattered electrons 50 on the positive potential electrode 44 instantaneously transits from a zero state to a state in which a certain number of backscattered electrons are radiated. Since the positive potential of the positive potential electrode 44 is due to the accumulation of positive charges in the electrode, an instantaneous change in the inflow electrons causes an instantaneous potential change of the positive potential electrode 44.

Therefore, in the configuration of the objective lens 117 according to the related art, the objective lens 117 is caused to shift from its focus due to the potential change of the positive potential electrode 44, leading to an increase in beam spot size and a decrease in secondary electron detection efficiency. In addition, since the inspection data cannot be used until the potential returns to its original value, the throughput of the inspection decreases.

On the other hand, according to the present embodiment, as shown in FIG. 2, since the ground electrode 45 is disposed between the Wehnelt electrode 41 and the positive potential electrode 44, a large number of backscattered electrons 50 emitted from the sample 30 are radiated on the ground electrode 45, and the radiation of backscattered electrons 50 on the positive potential electrode 44 can be reduced. Therefore, it is possible to reduce a potential change of the positive potential electrode 44 immediately after blanking release, and it is possible to reduce an increase in beam spot size and a decrease in secondary electron detection efficiency due to the potential change of the positive potential electrode 44. Since the backscattered electrons 50 colliding with the ground electrode 45 are rapidly discharged, the potential change of the ground electrode 45 is much smaller than the potential change of the positive potential electrode 44, and even if the potential change occurs, the recovery of the potential of the ground electrode 45 is much faster than the recovery of the potential of the positive potential electrode 44.

The backscattered electrons 50 emitted from the sample 30 fly to spread from the optical axis. Since the ground electrode 45 has no mechanism for positively collecting the backscattered electrons 50, most of the backscattered electrons passing through the hole of the ground electrode 45 can collide with the positive potential electrode 44. In particular, since the efficiency of collection of the backscattered electrons 50 having small initial energy in the ground electrode 45 is low, it is desirable to use a ground electrode 45 having a smaller inner diameter. For example, the inner diameter of the ground electrode 45 may be smaller than the inner diameter of the positive potential electrode 44.

By making the inner diameter of the ground electrode 45 sufficiently smaller than the inner diameter of the positive potential electrode 44, it is possible to more effectively reduce the radiation of the backscattered electrons 50 on the positive potential electrode 44. Therefore, in a case where the inner diameter of the positive potential electrode 44 is 1, the inner diameter of the ground electrode 45 is preferably 0.7 or less.

Meanwhile, collision of the secondary electrons with the ground electrode 45 leads to a decrease in secondary electron detection efficiency, which is not desirable. Therefore, in a case where the inner diameter of the positive potential electrode 44 is 1, the inner diameter of the ground electrode 45 is preferably 0.2 or more.

Next, specific examples according to the present embodiment will be described.

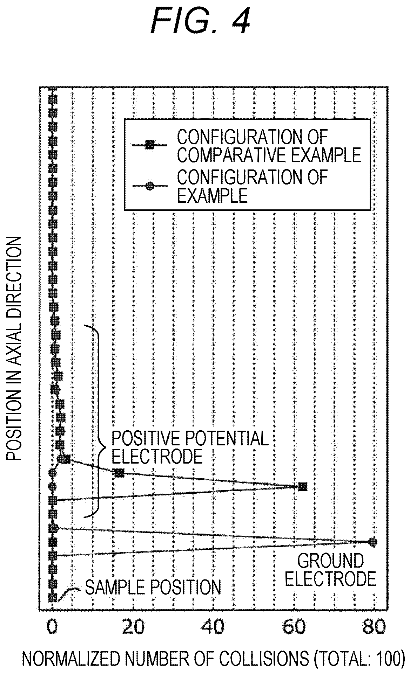

In a case where the acceleration energy of the primary electron beam is 30 keV and the potential of the sample 30 is -27 kV, electrons having energy of 0 to 3 keV are emitted from the sample 30. Among the electrons, those having maximum energy of 3 keV were subjected to calculations of electron trajectories by the inventors of the present application in a case where a predetermined number of electrons were emitted from the sample 30 at an opening angle according to Lambert's cosine law in each of a configuration of an example according to the present embodiment (see FIG. 2) and a configuration of a comparative example in which the ground electrode 45 was not provided (see FIG. 3), and frequency distributions of electron collision positions were obtained. FIG. 4 is a graph showing an example of frequency distributions of electron collision positions. Here, the calculation was performed under a condition in which +30 kV was applied to the positive potential electrode 44. In the configuration of the example, in a case where the inner diameter of the positive potential electrode 44 was set to 1, the inner diameter of the ground electrode 45 was set to 2/3.

As shown in FIG. 4, it was found that, in a case where a total number of the backscattered electrons is 100, more than 80 backscattered electrons collide with the positive potential electrode 44 in the configuration of the comparative example in which the ground electrode 45 is not provided, whereas most of the backscattered electrons can be made to collide with the ground electrode 45 in the configuration of the example according to the present embodiment.

Although the embodiments have been described by way of example, the scope of the present technology is not limited thereto, and changes and modifications can be made according to the purpose within the scope described in the claims. In addition, the embodiments can be appropriately combined within the scope in which the processing contents do not contradict each other.

## Claims

1. An electron beam inspection device comprising:
a primary optical system that irradiates a sample on a stage with a primary electron beam including a plurality of primary electrons; and a secondary optical system that detects, with a detector, a secondary electron beam including a plurality of secondary electrons emitted from the sample irradiated with the primary electron beam,
wherein an objective lens that forms an image of the primary electron beam on the sample is provided,
a negative potential is applied to the sample, and
the objective lens has
an electromagnetic lens that has a Wehnelt electrode that is disposed to face the sample and made of a high-permeability material and to which a negative potential is applied, and a yoke that is disposed on a side opposite to the sample as viewed from the Wehnelt electrode, is magnetically connected to the Wehnelt electrode, and is electrically insulated, and forms a magnetic field in a gap between an inner-diameter-side end part of the Wehnelt electrode and an inner-diameter-side end part of the yoke,
a positive potential electrode that is disposed on a side opposite to the sample as viewed from the Wehnelt electrode and to which a positive potential is applied, and
a ground electrode that is disposed between the Wehnelt electrode and the positive potential electrode to inhibit collision of backscattered electrons emitted from the sample with the positive potential electrode, and is electrically grounded.

2. The electron beam inspection device according to claim 1,
wherein an inner diameter of the ground electrode is smaller than an inner diameter of the positive potential electrode.

3. The electron beam inspection device according to claim 2,
wherein in a case where the inner diameter of the positive potential electrode is 1, the inner diameter of the ground electrode is 0.7 or less.

4. The electron beam inspection device according to claim 2,
wherein in a case where the inner diameter of the positive potential electrode is 1, the inner diameter of the ground electrode is 0.2 or more.

5. The electron beam inspection device according to claim 3,
wherein in a case where the inner diameter of the positive potential electrode is 1, the inner diameter of the ground electrode is 0.2 or more.
